# EUROPÄISCHE PATENTSCHRIFT

(11) **EP 3 966 579 B1**
(45) Veröffentlichungstag und Bekanntmachung des Hinweises auf die Patenterteilung: **18.09.2024**
(21) Anmeldenummer: 20727140.4
(22) Anmeldetag: 07.05.2020
(51) Int. Cl.: G01R 31/367, G01R 31/371, G01R 31/392, B60L 3/12, B60L 58/16, B60L 58/26, B60L 58/27

(54) **SERVER-SEITIGE CHARAKTERISIERUNG VON WIEDERAUFLADBAREN BATTERIEN**
SERVER-SIDE CHARACTERISATION OF RECHARGEABLE BATTERIES
CARACTÉRISATION CÔTÉ SERVEUR DE BATTERIES RECHARGEABLES

(30) Priorität: 08.05.2019 DE 102019111979
(43) Veröffentlichungstag der Anmeldung: 16.03.2022
(73) Patentinhaber: TWAICE Technologies GmbH, 80807 München (DE)
(72) Erfinder: BAUMANN, Michael, 80805 München (DE)
(74) Vertreter: Kraus & Lederer PartGmbB
(86) Internationale Anmeldenummer: PCT/DE2020/100380
(87) Internationale Veröffentlichungsnummer: WO 2020/224724

(56) Entgegenhaltungen:
- WO-A1-2017/182497
- WO-A1-2019/017991
- WO-A1-2019/053131
- CN-A- 108 279 383
- BAUMANN MICHAEL ET AL: "Cloud-connected battery management for decision making on second-life of electric vehicle batteries", 2018 THIRTEENTH INTERNATIONAL CONFERENCE ON ECOLOGICAL VEHICLES AND RENEWABLE ENERGIES (EVER), IEEE, 10 April 2018 (2018-04-10), pages 1 - 6, XP033348622, DOI: 10.1109/EVER.2018.8362355
- LEO WILDFEUER ET AL: "Concept for a hybrid semi-empirical and data-based model for state-of-health monitoring and aging prediction of li-ion battery packs", 1 January 2019 (2019-01-01), XP055716852, Retrieved from the Internet <URL:https://www.researchgate.net/profile/Leo_Wildfeuer/publication/330765254_Concept_for_a_hybrid_semi-empirical_and_data-based_model_for_state-of-health_monitoring_and_aging_prediction_of_li-ion_battery_packs/links/5c536599299bf12be3f10581/Concept-for-a-hybrid-semi-empirical-and-data-based-model-for-st> DOI: 10.13140/rg.2.2.29057.51043

## Beschreibung

### TECHNISCHES GEBIET

Verschiedene Beispiele der Erfindung betreffen Techniken zur Charakterisierung einer Batterie. Insbesondere betreffen Verschiedene Beispiele der Erfindung Techniken zur Server-seitigen Charakterisierung, um eine Alterungsschätzung für ein Vorhersageintervall zu erhalten.

### HINTERGRUND

Wiederaufladbare Batterien, beispielsweise Traktions-Batterien von Elektrofahrzeugen, weisen eine begrenzte Lebensdauer auf. Zum Beispiel kann der sogenannte Gesundheitszustand (engl. state of health, SOH) von Batterien über der Zeit abnehmen, beispielsweise als Funktion von Ladezyklen. Dies kann zum Beispiel im Zusammenhang mit dem zuverlässigen Betrieb eines entsprechenden Batteriegetriebenen Geräts problematisch sein. Der SOH ist typischerweise im Zusammenhang mit Kapazität und Impedanz einer Batterie bestimmt.

Es sind Techniken bekannt, um den SOH der Batterie im Ist-Zustand zu bestimmen. Beispielsweise kann eine solche Bestimmung durch ein Batteriemanagementsystem (BMS) der Batterie erfolgen. Dabei kann aber der SOH der Batterie im Ist-Zustand nur teilweise aussagekräftig sein, inwiefern die Batterie im zukünftigen Betrieb zuverlässig eingesetzt werden kann.

Baumann, Michael, Stephan Rohr, and Markus Lienkamp. "Cloud-connected battery management for decision making on second-life of electric vehicle batteries." 2018 Thirteenth International Conference on Ecological Vehicles and Renewable Energies (EVER). IEEE, 2018 offenbart die Verwendung eines thermischen Modells und eines elektrischen Modells für die Simulation.

Ebenso offenbart Wildfeuer, Leo, Michael Baumann, and Markus Lienkamp. "Concept for a hybrid semi-empirical and data-based model for state-of-health monitoring and aging prediction of li-ion battery packs." AABC Europe (2019) die Verwendung eines thermischen Modells und eines elektrischen Modells für die Simulation.

WO 2019/053131 A1 offenbart, dass ein parametrisiertes elektrisches Modell und ein parametrisiertes thermisches Modell dazu verwendet werden, um elektrische Parameter und thermische Parameter zu bestimmen.

### KURZE BESCHREIBUNG DER ERFINDUNG

Deshalb besteht ein Bedarf für verbesserte Techniken zur Charakterisierung von wiederaufladbaren Batterien. Insbesondere besteht ein Bedarf für Techniken, die zuverlässige Aussagen über den zukünftigen Betrieb der Batterie bereitstellen können.

Diese Aufgabe wird gelöst von den Merkmalen der unabhängigen Patentansprüche. Die Merkmale der abhängigen Patentansprüche definieren Ausführungsformen.

Ein Verfahren zur Server-seitigen Charakterisierung einer wiederaufladbaren Batterie umfasst das Erhalten von Betriebswerten für eine Kapazität der Batterie sowie für eine Impedanz der Batterie. Außerdem umfasst das Verfahren das Durchführen von mindestens einer Zustandsvorhersage für die Batterie, basierend auf diesen Betriebswerten. Dabei ist jede der mindestens einen Zustandsvorhersage mit einer entsprechenden Betriebsrandbedingung der Batterie assoziiert. Außerdem umfasst jede der mindestens einen Zustandsvorhersage mehrere Iterationen. Dabei wird in jeder Iteration eine Simulation eines elektrischen Zustands der Batterie sowie eines thermischen Zustands der Batterie durchgeführt und darauf basierend wird eine Alterungsschätzung für die Kapazität und die Impedanz bestimmt. Die Alterungsschätzung aus einer ersten Iteration der jeweiligen Zustandsvorhersage wird dann für die Simulation in einer nachfolgenden zweiten Iteration der jeweiligen Zustandsvorhersage verwendet.

Ein Computerprogramm oder ein Computerprogramm-Produkt oder ein Computerlesbares Speichermedium umfasst Programmcode. Dieser Programmcode kann von einem Prozessor geladen werden und ausgeführt werden. Dies bewirkt, dass der Prozessor ein Verfahren zur Server-seitigen Charakterisierung einer wiederaufladbaren Batterie durchführt, wobei das Verfahren das Erhalten von Betriebswerten für eine Kapazität der Batterie sowie für eine Impedanz der Batterie umfasst. Außerdem umfasst das Verfahren das Durchführen von mindestens einer Zustandsvorhersage für die Batterie, basierend auf diesen Betriebswerten. Dabei ist jede der mindestens einen Zustandsvorhersage mit einer entsprechenden Betriebsrandbedingung der Batterie assoziiert. Außerdem umfasst jede der mindestens einen Zustandsvorhersage mehrere Iterationen. Dabei wird in jeder Iteration eine Simulation eines elektrischen Zustands der Batterie sowie eines thermischen Zustands der Batterie durchgeführt und darauf basierend wird eine Alterungsschätzung für die Kapazität und die Impedanz bestimmt. Die Alterungsschätzung aus einer ersten Iteration der jeweiligen Zustandsvorhersage wird dann für die Simulation in einer nachfolgenden zweiten Iteration der jeweiligen Zustandsvorhersage verwendet.

Ein Server umfasst einem Prozessor, der eingerichtet ist, um Programmcode zu laden und das obenstehend beschriebenen Verfahren zur Server-seitigen Charakterisierung einer wiederaufladbaren Batterie basierend auf dem Programmcode auszuführen.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang der vorliegenden Erfindung zu verlassen.

### KURZE BESCHREIBUNG DER FIGUREN

FIG. 1 illustriert schematisch ein System umfassend mehrere Batterien und einen Server gemäß verschiedenen Beispielen.
FIG. 2 illustriert Details einer Batterie gemäß verschiedenen Beispielen.
FIG. 3 illustriert Details eines Servers gemäß verschiedenen Beispielen.
FIG. 4 illustriert schematisch ein Flussdiagramm eines beispielhaften Verfahrens.
FIG. 5 illustriert schematisch Ergebnis von Alterungsschätzungen für mehrere Zustandsvorhersagen zur Charakterisierung eine Batterie gemäß verschiedenen Beispielen.
FIG. 6 ist ein Flussdiagramm eines beispielhaften Verfahrens, wobei FIG. 6 Details im Zusammenhang mit der Simulation eines elektrischen Zustandes und eines thermischen Zustands einer Batterie gemäß verschiedenen Beispielen illustriert.
FIG. 7 illustriert schematisch ein kollektives Betriebsprofil einer Batterie gemäß verschiedenen Beispielen.
FIG. 8 illustriert schematisch ein Ereignis-bezogenes Betriebsprofil einer Batterie gemäß verschiedenen Beispielen.
FIG. 9 illustriert schematisch ein Verfahren zum Bestimmen von Betriebswerten für eine Impedanz und eine Kapazität der Batterie gemäß verschiedenen Beispiele.
FIG. 10 illustriert schematisch eine Strom-Zeitreihe mit Sprungfenstern zum Bestimmen eines Betriebswerts für die Impedanz der Batterie gemäß verschiedenen Beispielen.
FIG. 11 illustriert schematisch eine Ruhespannung-Ladungszustand-Kennlinie sowie eine entsprechende Stauchung gemäß verschiedenen Beispielen.

### DETAILLIERTE BESCHREIBUNG VON AUSFÜHRUNGSFORMEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden Techniken im Zusammenhang mit der Charakterisierung von wiederaufladbaren Batterien beschrieben. Die hierin beschriebenen Techniken können im Zusammenhang mit unterschiedlichsten Typen von Batterien eingesetzt werden, beispielsweise im Zusammenhang mit Batterien auf Lithium-Ionen-Basis, wie z.B. Lithium-Nickel-Mangan-Cobaltoxid-Batterien oder Lithium-Manganoxid-Batterien.

Die hierin beschriebenen Batterien können in unterschiedlichen Anwendungsgebieten eingesetzt werden, beispielsweise für Batterien die in Geräten wie Kraftfahrzeugen oder Drohnen oder tragbaren elektronischen Geräten wie etwa Mobilfunkgeräte eingesetzt werden. Es wäre auch denkbar, die hierin beschriebenen Batterien in Form von stationären Energiespeichern einzusetzen.

Die hierin beschriebenen Techniken ermöglichen es, die Charakterisierung der Batterie auf Grundlage einer Zustandsvorhersage der Batterie vorzunehmen. Dies bedeutet, dass der Zustand der Batterie für ein gewisses Vorhersageintervall in der Zukunft prädiziert werden kann. Insbesondere kann eine Alterungsschätzung des SOH der Batterie für das Vorhersageintervall erfolgen.

Als allgemeine Regel nimmt der SOH für zunehmende Alterung der Batterie ab. Eine zunehmende Alterung kann vorliegen, wenn die Kapazität der Batterie abnimmt und/oder wenn die Impedanz der Batterie zunimmt.

Diese Zustandsvorhersage kann auf verschiedene Arten und Weisen eingesetzt werden. Zum Beispiel kann ein Ergebnis der Zustandsvorhersage dazu verwendet werden, um den Betrieb der Batterie anzupassen. Derart könnte zum Beispiel eine übermäßige Alterung der Batterie vermieden werden. Alternativ oder zusätzlich könnte auch eine Zweitverwendung der Batterie auf Grundlage des Ergebnisses der prädiktiven Zustandsbestimmung ermittelt werden. Zum Beispiel könnte bestimmt werden, ob die Batterie für einen bestimmten Einsatz noch geeignet ist oder aber aus dem Verkehr gezogen werden müsste. Eine weitere Möglichkeit des Einsatzes betrifft die gezielte Wartung und/oder Instandsetzung von Batterien in Abhängigkeit von der Zustandsvorhersage. Zum Beispiel wäre es möglich, solche Batterien zu warten oder auszutauschen etc., für welche ein verschlechterter SOH vorhergesagt wird.

Als allgemeine Regel können die hierin beschriebenen Techniken zur Zustandsvorhersage auf verschiedenen Ebenen eingesetzt werden: in einer einfachen Implementierung kann die Zustandsvorhersage auf Batterie-Ebene erfolgen, das heißt es kann eine integrale Alterungsschätzung quer über alle Batterieblöcke und Zellen der Batterie erfolgen. In weiteren Beispielen wäre es aber auch möglich, dass die Zustandsvorhersage aufgelöst für verschiedene Batterieblöcke oder sogar Zellen individueller Batterieblöcke erfolgt. Manchmal kann es möglich sein, dass eine Batterie zerlegt wird und einzelne Batterieblöcke entsorgt werden wobei andere Batterieblöcke weiterverwendet werden. In einem solchen Beispiel kann eine individuelle Zustandsvorhersage auf Batterieblock-Ebene erstrebenswert sein.

Verschiedene der hierin beschriebenen Beispiele können zumindest teilweise Server-seitig implementiert werden. Dies bedeutet, dass zumindest ein Teil der mit der Zustandsvorhersage assoziierten Logik auf einem zentralen Server, getrennt von der Batterie bzw. dem Batterie-betriebenen Gerät durchgeführt werden kann. Dazu kann insbesondere eine Kommunikationsverbindung zwischen dem Server und ein oder mehreren Managementsystemen der Batterie hergestellt werden. Durch die Implementierung zumindest eines Teils der Logik auf dem Server können besonders genaue und rechenintensive Modelle und/oder Simulationen im Zusammenhang mit der Zustandsvorhersage eingesetzt werden. Dies ermöglicht es, die Zustandsvorhersage besonders genau durchzuführen. Zudem kann es möglich sein, Daten für ein Ensemble von Batterien zu sammeln und zu verwerten, zum Beispiel im Zusammenhang mit maschinengelernten Modellen.

Verschiedene hierin beschriebene Beispiele können die Zustandsvorhersage während des Einsatzes der Batterie auf Grundlage von Messdaten von der Batterie durchführen. Dies bedeutet, dass insbesondere zu einem bestimmten Zeitpunkt während des Lebens der Batterie - mit reduziertem SOH - die Zustandsvorhersage durchgeführt wird. Die Batterie kann sich dann im Feldeinsatz befinden. Derart kann es insbesondere möglich sein, auch das bisherige Alterungsverhalten der Batterie zu berücksichtigen. Auch dies ermöglicht es, die prädiktive Zustandsbestimmung besonders genau durchzuführen.

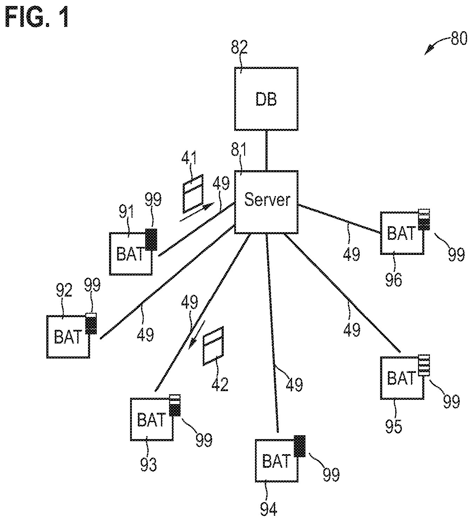

FIG. 1 illustriert Aspekte im Zusammenhang mit einem System 80. Das System 80 umfasst einen Server 81, der mit einer Datenbank 82 verbunden ist. Außerdem umfasst das System 80 Kommunikationsverbindungen 49 zwischen dem Server 81 und jeder von mehreren Batterien 91-96. Die Kommunikationsverbindungen 49 könnten zum Beispiel über ein Mobilfunknetzwerk implementiert werden.

In FIG. 1 ist beispielhaft illustriert, dass die Batterien 91-96 über die Kommunikationsverbindungen 49 Zustandsdaten 41 an den Server 81 senden können. Beispielsweise wäre es möglich, dass die Zustandsdaten 41 indikativ für ein oder mehrere Betriebswerte der jeweiligen Batterie 91-96 sind. Die Zustandsdaten 41 könnten Ereignis-getrieben gesendet werden oder gemäß einem vorgegebenen Zeitschema.

Als allgemeine Regel können Betriebswerte zum Beispiel indikativ für den Ist-Wert des SOH der jeweiligen Batterie 91-96 sein. Die Betriebswerte können also zum Beispiel indikativ für die Kapazität der jeweiligen Batterie 91-96 sein. Alternativ oder zusätzlich können die Betriebswerte auch indikativ für den Ist-Wert der Impedanz der jeweiligen Batterie 91-96 sein. Alternativ oder zusätzlich wäre es aber auch möglich, dass die Betriebswerte indikativ für ein Betriebsprofil der jeweiligen Batterie 91-96 sind. Zum Beispiel könnte ein Ereignis-bezogenes Betriebsprofil und/oder ein kollektives Betriebsprofil durch die Betriebswerte indiziert werden.

In FIG. 1 ist auch beispielhaft illustriert, dass der Server 81 über die Kommunikationsverbindungen 49 Steuerdaten 42 an die Batterien 91-96 senden kann. Beispielsweise wäre es möglich, dass die Steuerdaten 42 ein oder mehrere Betriebsgrenzen für den zukünftigen Betrieb der jeweiligen Batterie 91-96 indizieren. Dabei wäre es zum Beispiel denkbar, dass diese Betriebsgrenzen basierend auf einer Mensch-Maschine-Indikation ermittelt werden. Zum Beispiel könnten die Steuerdaten ein oder mehrere Steuerparameter für ein Thermomanagement der jeweiligen Batterie 91-96 (also z.B. eine Auswahl der Kühlleistung) und/oder ein Lademanagement der jeweiligen Batterie 91-96 (also z.B. eine Begrenzung des Ladestroms) indizieren. Durch Verwendung der Steuerdaten 42 kann der Server 81 also den Betrieb der Batterien 91-96 beeinflussen bzw. steuern.

In FIG. 1 ist außerdem für jede der Batterien 91-96 schematisch der jeweilige SOH 99 illustriert. Als allgemeine Regel kann der SOH 99 einer Batterie 91-96 je nach Implementierung ein oder mehrere unterschiedliche Kenngrößen umfassen. Typische Kenngrößen des SOH 99 können beispielsweise sein: elektrische Kapazität, d. h. die maximal mögliche gespeicherte Ladung; und/oder elektrische Impedanz, d. h. der Frequenzgang des Widerstands bzw. Wechselstromwiderstand als Verhältnis zwischen elektrischer Spannung und elektrischer Stromstärke.

Nachfolgend werden Techniken zur Zustandsvorhersage beschrieben, die es ermöglichen, den SOH 99 für jede der Batterien 91-96 während des Einsatzes der Batterien 91-96 für ein Vorhersageintervall zu prädizieren. Dies bedeutet, dass zum Beispiel die elektrische Impedanz und/oder die elektrische Kapazität vorhergesagt werden können.

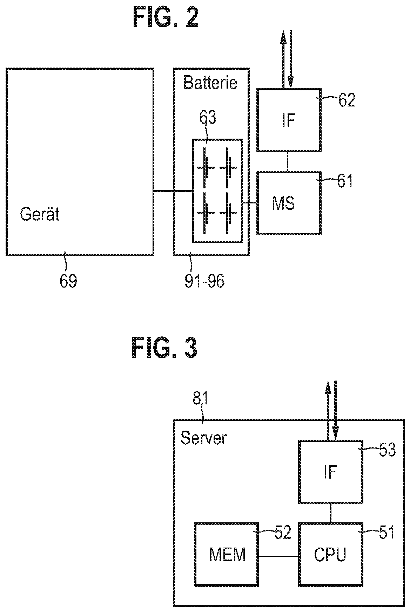

FIG. 2 illustriert Aspekte im Zusammenhang mit den Batterien 91-96. Die Batterien 91 - 96 sind mit einem jeweiligen Gerät 69 gekoppelt. Dieses Gerät wird durch elektrische Energie aus der jeweiligen Batterie 91-96 getrieben.

Die Batterien 91-96 umfassen bzw. sind assoziiert mit ein oder mehreren Managementsysteme 61, z.B. ein BMS oder eine andere Steuerlogik wie eine onboard-unit im Falle eines Fahrzeugs. Das Managementsystem 61 kann zum Beispiel durch Software auf einem CPU implementiert sein. Alternativ oder zusätzlich könnte zum Beispiel ein Applikations-spezifischer Schaltkreis (ASIC) oder ein Feldprogrammierbares gated array (FPGA) verwendet werden. Die Batterien 91-96 könnten z.B. über ein Bussystem mit dem Managementsystem 61 kommunizieren. Die Batterien 91-96 umfassen auch eine Kommunikationsschnittstelle 62. Das Managementsystem 61 kann über die Kommunikationsschnittstelle 62 eine Kommunikationsverbindung 49 mit dem Server 81 aufbauen.

Während in FIG. 2 das Managementsystem 61 separat von den Batterien 91-96 gezeichnet ist, wäre es in anderen Beispielen auch möglich, dass das Managementsystem 61 Teil der Batterien 91-96 ist.

Außerdem umfassen die Batterien 91-96 ein oder mehrere Batterieblöcke 63. Jeder Batterieblock 63 umfasst typischerweise eine Anzahl von parallel geschalteten und/oder seriell geschalteten Batteriezellen. Dort kann elektrische Energie gespeichert werden.

Typischerweise kann das Managementsystem 61 auf ein oder mehrere Sensoren in den ein oder mehreren Batterieblöcken 63 zurückgreifen. Die Sensoren können zum Beispiel den Stromfluss und/oder die Spannung in zumindest einigen der Batteriezellen messen. Die Sensoren können alternativ oder zusätzlich auch andere Größen im Zusammenhang mit zumindest einigen der Batteriezellen messen, beispielsweise Temperatur, Volumen, Druck, etc. Das Managementsystem 61 kann dann eingerichtet sein, um auf Grundlage von ein oder mehreren solchen Messwerten von Sensoren einen aktuellen SOH 99 für die jeweilige Batterie 91-96 bzw. optional auch für individuelle Batterieblöcke zu bestimmen, d. h. also zum Beispiel die elektrische Kapazität und/oder die elektrische Impedanz der Batterie zu bestimmen und in Form von Betriebsdaten an den Server 81 zu senden. Das Managementsystem 61 kann auch eingerichtet sein, um ein Thermomanagement und/oder ein Lademanagement der jeweiligen Batterie 91-96 zu implementieren. Im Zusammenhang mit dem Thermomanagement könnte das Managementsystem 61 zum Beispiel eine Kühlung und/oder einer Heizung steuern. Im Zusammenhang mit dem Lademanagement könnte das Managementsystem 61 zum Beispiel eine Laderate oder eine Tiefe von Entladungen steuern. Das Managementsystem 61 kann also ein oder mehrere Betriebsrandbedingungen des Betriebs der jeweiligen Batterie 91-96 einstellen.

FIG. 3 illustriert Aspekte im Zusammenhang mit dem Server 81. Der Server 81 umfasst einen Prozessor 51 sowie einen Speicher 52. Der Speicher 52 kann ein flüchtiges Speicherelement und/oder ein nicht-flüchtiges Speicherelement umfassen. Außerdem umfasst der Server 81 auch eine Kommunikationsschnittstelle 53. Der Prozessor 51 kann über die Kommunikationsschnittstelle 53 eine Kommunikationsverbindung 49 mit jeder der Batterien 91-96 und der Datenbank 82 aufbauen. Der Server 81 könnte weiterhin über eine Schnittstelle verfügen, um mit einem Benutzer kommunizieren, zum Beispiel auch mit einem Benutzer einer der Batterien 91-96. Das bedeutet, dass der Server 81 zur Mensch-Maschine-Interaktion eingerichtet sein kann.

Zum Beispiel kann Programmcode im Speicher 52 gespeichert sein und vom Prozessor 51 geladen werden. Der Prozessor 51 kann dann den Programmcode ausführen. Das Ausführen des Programmcodes bewirkt, dass der Prozessor 51 ein oder mehrere der folgenden Prozesse ausführt, wie sie im Zusammenhang mit den verschiedenen Beispielen hierin im Detail beschrieben sind: Charakterisierung von Batterien 91-96; Durchführen von ein oder mehreren Zustandsvorhersagen für eine oder mehrere der Batterien 91-96, beispielsweise basierend auf Betriebswerten die von den entsprechenden Batterien 91-96 über die Kommunikationsverbindung als Zustandsdaten 40 empfangen werden; Durchführen einer elektrischen Simulation von Batterien 91-96; Durchführen einer thermischen Simulation von Batterien 91-96; Durchführen einer Alterungsschätzung von Batterien basierend auf ein oder mehreren Betriebsprofilen; Senden von Steuerdaten an Batterien 91-96, zum Beispiel um Betriebsrandbedingungen einzustellen; Hinterlegen von einem Ergebnis einer Charakterisierung einer entsprechenden Batterie 91-96 in einer Datenbank 82; Durchführen einer Mensch-Maschine-Interaktion auf Grundlage eines Ergebnisses der Charakterisierung einer entsprechenden Batterie 91-96, z.B. zur Auswahl von Betriebsgrenzen für ein Betriebsprofil, etc..

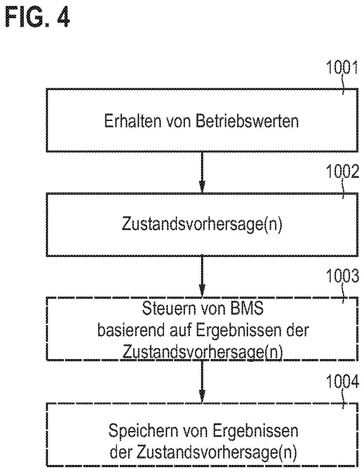

FIG. 4 ist ein Flussdiagramm eines beispielhaften Verfahrens. Das Verfahren wird von einem Server ausgeführt. Das Verfahren dient der Server-seitigen Charakterisierung einer Batterie. Zum Beispiel wäre es möglich, dass das Verfahren gemäß FIG. 4 vom Prozessor 51 des Servers 81 basierend auf Programmcode aus dem Speicher 52 ausgeführt wird (vgl. FIG. 3). Optionale Blöcke sind in FIG. 4 mit gestrichelten Linien dargestellt.

Zunächst werden in Block 1001 ein oder mehrere Betriebswerte von der zu charakterisierenden Batterie erhalten. Dazu können in Block 1001 zum Beispiel Zustandsdaten über eine Kommunikationsverbindung zwischen der Batterie und dem Server empfangen werden.

Die ein oder mehreren Betriebswerte können z.B. einen SOH der Batterie betreffen. Die ein oder mehreren Betriebswerte können zum Beispiel eine Kapazität der Batterie und/oder eine Impedanz der Batterie betreffen. Im allgemeinen wäre es auch möglich, dass ein oder mehrere weitere oder andere charakteristische Größen des Betriebs der Batterie durch die ein oder mehreren Betriebswerte indiziert werden. Zum Beispiel wäre es in manchen Beispielen möglich, dass Strom-Daten (beispielsweise eine Zeitreihe) und/oder Spannungs-Daten (beispielsweise eine Zeitreihe) durch die Betriebswerte indiziert werden. Dies bedeutet, dass die Betriebswerte zum Beispiel einen Zeitverlauf des Stroms in ein oder mehreren Zellen eines Batterieblocks der Batterie beschreiben könnten bzw. einen Zeitverlauf der elektrischen Spannungen ein oder mehreren Zellen eines Batterieblocks der Batterie beschreiben könnten. Die Betriebswerte könnten zum Beispiel auch eine Temperatur in ein oder mehreren Bereichen einer Batterie beschreiben. Die Betriebswerte könnten zum Beispiel eine entsprechende Zeitreihe von Temperaturdaten beschreiben. Alternativ oder zusätzlich wäre es auch möglich, dass die Betriebswerte ein oder mehrere Betriebsprofile der Batterien einem Überwachungsintervall indizieren.

Als allgemeine Regel könnte ein Betriebsprofil zum Beispiel ein oder mehrere der folgenden charakteristischen Größen für den Betrieb der Batterie beschreiben: verwendete Entladetiefe (engl. depth of discharge); mittlere Entladetiefe; verwendete Laderate; verwendete Entladerate; typische Temperatur im Betrieb; Häufigkeit von Ladevorgängen; Häufigkeit von Entladevorgängen; Zeitdauer zwischen zwei Ladevorgängen; Zeitdauer zwischen zwei Entladevorgängen; etc. Es können Ereignis-bezogene Betriebsprofile und/oder kollektive Betriebsprofile verwendet werden.

Anschließend erfolgt in Block 1002 das Durchführen von ein oder mehreren Zustandsvorhersagen für die Batterie, um diese zu charakterisieren.

Sofern mehrere Zustandsvorhersagen in Block 1002 durchgeführt werden, können diese mit unterschiedlichen Randbedingungen des Betriebs der Batterie assoziiert sein. Zum Beispiel könnten die Betriebsrandbedingungen, die in Block 1002 berücksichtigt werden, ein oder mehrere der folgenden Elemente betreffen: ein Steuerparameter eines Thermomanagements der Batterie und/oder ein Steuerparameter eines Lademanagements der Batterie. Im Allgemeinen können die Betriebsrandbedingungen bestimmte Bedingungen für den Betrieb der Batterie bestimmen, die losgelöst sind von dem konkreten Betriebsprofil, das zum Beispiel bestimmt wird durch die Benutzung des jeweiligen Geräts 69, das mit der entsprechenden Batterie assoziiert ist (d. h. also zum Beispiel Belastung, entnommene Ladung, Entladerate, Laderate, Entladetiefe, etc.).

Den ein oder mehreren Zustandsvorhersagen in Block 1002 kann ein Betriebsprofil zugrunde liegen, welches sich aus einem Betriebsprofil herleitet, welches für die jeweilige Batterie in einem Überwachungsintervall durch die Betriebswerte aus Block 1001 indiziert wird. Zum Beispiel wäre es möglich, dass das für die ein oder mehreren Zustandsvorhersagen in Block 1002 verwendete Betriebsprofil basierend auf Messungen an der Batterie im Überwachungsintervall bestimmt wird. Dies bedeutet, dass z.B. die gemessene DOD und/oder gemessene SOC-Zyklen und/oder gemessene Laderaten usw. im Zusammenhang mit der ein oder den mehreren Zustandsvorhersagen in Block 1002 verwendet werden können. Durch die Verwendung eines Betriebsprofil des für die ein oder mehreren Zustandsvorhersagen in Block 1002, welches sich am konkreten Betrieb der entsprechenden Batterie im Überwachungsintervall orientiert, kann eine besonders zuverlässige bzw. genaue Zustandsvorhersage ermöglicht werden.

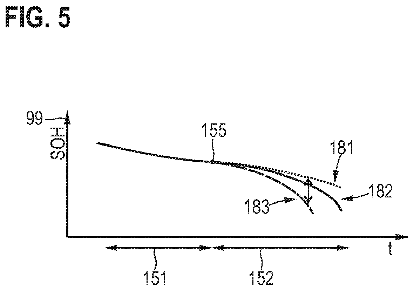

Die Zustandsvorhersage kann als Ergebnis einen Zeitverlauf der Alterung für ein Vorhersageintervall ausgeben. Das ist in FIG. 5 dargestellt.

FIG. 5 illustriert Aspekte im Zusammenhang mit der Alterung einer Batterie, beispielsweise einer der Batterien 91-96 aus FIG. 1.in FIG. 5 ist der SOH 99 als Funktion der Zeit dargestellt. Während eines Überwachungsintervalls 151 nimmt der SOH 99 ab. Zum Beispiel könnte diese Abnahme des SOH 99 gemessen werden, indem auf Betriebswerte für die Kapazität und die Impedanz der jeweiligen Batterie vom entsprechenden Managementsystem (vergleiche FIG. 2, wo ein Managementsystem 61 dargestellt ist) zurückgegriffen wird.

Dann erfolgt zum Zeitpunkt 155 eine Charakterisierung der Batterie mittels Durchführen von mehreren Zustandsvorhersagen 181-183 für die Batterie. Die Zustandsvorhersagen 181-183 liefern als Ergebnis eine Vorhersage für die Alterung der Batterie, d.h. den SOH 99 während eines Vorhersageintervalls 152. Aus FIG. 5 ist ersichtlich, dass der SOH 99 zwischen den verschiedenen Zustandsvorhersagen 181-183 variiert, was an den unterschiedlichen verwendeten Betriebsrandbedingungen liegt. Die Betriebsrandbedingungen können sich hinsichtlich Temperatur, Ruhe-Ladezustand, Lade- und Entladerate, Lade- und Entladeendpunkt, Zyklentiefe und/oder mittlerem Ladezustand bei Ladung und Entladung sowie Kombinationen davon unterscheiden. Zum Beispiel wäre es möglich, dass die Zustandsvorhersage 181 - die in einer vergleichsweise geringen Abnahme des SOH 99 als Funktion der Zeit während des Vorhersageintervalls 152 resultiert - im Vergleich zur Zustandsvorhersage 183 - die in einer vergleichsweise starken Abnahme des SOH 99 als Funktion der Zeit während des Vorhersageintervalls 152 resultiert - einen anderen Konfiguration des Thermomanagements annimmt. Zum Beispiel könnte das Thermomanagement der Batterie tiefere Betriebstemperaturen durch aktive Kühlung als Betriebsrandbedingung für die Zustandsvorhersage 181 ermöglichen.

Während voranstehend ein Beispiel beschrieben wurde, bei dem die Zustandsvorhersagen 181-183 mit unterschiedlichen Betriebsrandbedingungen assoziiert sind, wäre es in anderen Beispielen alternativ oder zusätzlich möglich, das Betriebsprofil für die mehreren Zustandsvorhersagen zu variieren. Z.B. könnten verschiedene Zustandsvorhersagen mit unterschiedlichen DODs und/oder unterschiedlichen maximalen SOCs und/oder unterschiedlichen Laderaten usw. assoziiert sein. Das bedeutet, dass die Strategie für den Betrieb der Batterie verändert werden kann.

Jetzt wieder bezugnehmend auf FIG. 4: als allgemeine Regel können die Ergebnisse der ein oder mehreren Zustandsvorhersagen 181-183 aus Block 1002 auf unterschiedliche Arten und Weisen verwertet werden.

In einem Beispiel wäre es möglich, dass ein Managementsystem, welches mit der jeweiligen Batterie assoziiert ist, basierend auf den Ergebnissen der ein oder mehreren Zustandsvorhersagen aus Block 1002 gesteuert wird, siehe Block 1003. In diesem Zusammenhang wäre es beispielsweise möglich, dass mehrere Zustandsvorhersagen Block 1002 durchgeführt werden und entsprechende Ergebnisse der mehreren Zustandsvorhersagen miteinander verglichen werden. Dann könnte basierend auf einem Vergleich der Ergebnisse die Steuerung des Managementsystems erfolgen. Dies könnte z.B. unter Berücksichtigung einer Mensch-Maschine-Interaktion auf Grundlage der Ergebnisse erfolgen. Zum Beispiel wäre es möglich, dass Steuerdaten (vergleiche FIG. 1: Steuerdaten 42) basierend auf dem Vergleichen der Ergebnisse bestimmt werden und diese Steuerdaten an das Managementsystem gesendet werden. Als allgemeine Regel können ein oder mehrere unterschiedliche Parameter des Betriebs der jeweiligen Batterie eingestellt werden. Zum Beispiel wäre es möglich, dass die Steuerdaten ein oder mehrere Betriebsgrenzen für den zukünftigen Betrieb der Batterie spezifizieren. Alternativ oder zusätzlich wäre es auch möglich, dass die Steuerdaten ein oder mehrere Steuerparameter für ein Thermomanagement und/oder ein Lademanagement der Batterie spezifizieren. Durch eine solche Rückkopplung der Ergebnisse von ein oder mehreren Zustandsvorhersagen bzw. im Allgemeinen der Charakterisierung der Batterie kann es möglich sein, einen besonders nachhaltigen Betrieb der jeweiligen Batterie zu ermöglichen.

Dafür werden nachfolgend ein paar Beispiele erläutert: Beispielsweise könnten Betriebsgrenzen für den zukünftigen Betrieb der jeweiligen Batterie derart gesetzt werden, dass die Batterie nur vergleichsweise langsam altert, d. h. dass der SOH 99 als Funktion der Zeit nur langsam abnimmt. Zum Beispiel wäre es denkbar, dass ein Ergebnis der Charakterisierung an den Benutzer der jeweiligen Batterie ausgegeben wird, über eine geeignete Mensch-Maschinen-Schnittstelle. Dies könnte zum Beispiel über eine Webseite erfolgen, auf welcher die Zustandsvorhersagen für unterschiedliche Betriebsprofile der Batterie dargestellt werden. Eine Mobil-App wäre denkbar. Eine Push-Information könnte gesendet werden, wenn das Ergebnis der Charakterisierung verfügbar ist. Dann könnte der Benutzer eines der Batterieprofile auswählen und anschließend kann der zukünftige Betrieb der jeweiligen Batterie entsprechend angepasst werden, um mittels Betriebsrandbedingungen das ausgewählte Betriebsprofil umzusetzen. Der Benutzer kann also unter Berücksichtigung sowohl der erwarteten Alterung, wie auch der durch die Wahl eines bestimmten Betriebsprofils bedingten Einschränkung des Betriebs der Batterie eine Entscheidung treffen, wie die Batterie zukünftig belastet werden soll.

Wenn zum Beispiel im Rahmen der Zustandsvorhersagen bestimmte Betriebsrandbedingungen der Batterie identifiziert werden, die in einer besonders starken Alterung der Batterie resultieren, so könnten diese durch geeignete Definition von Betriebsgrenzen aus dem zukünftigen Betrieb der Batterie ausgenommen werden. Derart können zum Beispiel Fertigungsfehler etc. der Batterie durch geeignetes Steuern des Betriebs kompensiert werden. Es wäre z.B. möglich, dass die verschiedenen Zustandsvorhersagen mit unterschiedlichen Betriebsrandbedingungen assoziiert sind, also z.B. anderen Betriebsparametern für ein Thermo-Management oder ein Lade-Management (z.B. Ladestrom). Dann kann durch einen Vergleich der Alterung für die Wahl verschiedener Betriebsrandbedingungen rückgeschlossen werden, wie die Betriebsgrenzen im Zusammenhang mit den Betriebsrandbedingungen gewählt werden sollten, um exzessiver Alterung vorzubeugen. Eine solche Auswahl kann z.B. durch den Benutzer erfolgen, etwa über einen Frontend-Zugriff auf den Server oder eine andere Mensch-Maschine-Schnittstelle. Der Benutzer könnte also z.B. den maximalen Ladestrom festlegen, wobei gleichzeitig die Auswirkung dieser Auswahl auf die Alterung auf Grundlage der hierin beschriebenen Charakterisierung an den Benutzer rückgekoppelt wird.

Wenn in einem weiteren Beispiel im Rahmen der Zustandsvorhersagen bestimmte Betriebsprofile der Batterie identifiziert werden, die in einer besonders starken Alterung der Batterie resultieren, so könnten diese durch geeignete Definition von Betriebsgrenzen aus dem zukünftigen Betrieb der Batterie ausgenommen werden. Es wäre z.B. möglich, dass die verschiedenen Zustandsvorhersagen mit unterschiedlichen Betriebsprofilen assoziiert sind. Dann kann durch einen Vergleich der Alterung für die Wahl verschiedener Betriebsrandbedingungen rückgeschlossen werden, wie die Betriebsgrenzen im Zusammenhang mit dem Betriebsprofil gewählt werden sollten, um exzessiver Alterung vorzubeugen. Nachfolgend wird dazu ein konkretes Beispiel beschrieben: Z.B. könnte ein Mikronetz mit stationärem Energiespeicher als wiederaufladbare und Solaranlage vorgesehen sein. Das Mikronetz kann über einen Anschluss an ein Hauptstromnetz verfügen und sog. peak shaving betreiben, d.h. Lastspitzen des Hauptstromnetzes (typischerweise in den Abendstunden) abfedern, durch Einspeisung von Energie in das Hauptstromnetz. Die Batterien des stationären Energiespeichers werden aber zur Mittagszeit geladen, weil dann die erzeugte Energie der Solaranlage besonders stark ist. Das Betriebsprofil kann eine Laderate und eine Entladerate der Batterien bezeichnen. Das Betriebsprofil kann dann in Abhängigkeit von Zustandsvorhersagen angepasst werden. Das heißt, es können unterschiedliche Betriebsstrategien für das Mikronetz bestimmt werden. In einem weiteren Beispiel könnten für ein batteriebetriebenes Produkt in mobiler Anwendung, bspw. ein Elektroauto oder -bus, eine Zustandsvorhersage für verschiedene Ladestrategien getroffen werden. Darauf basierend könnte das Lademanagement und/oder das Thermomanagement der Batterien vor oder während dem Laden angepasst werden, um exzessive Alterung zu verhindern.

Als allgemeine Regel wäre es optional möglich, beim Bestimmen der Steuerdaten auch ein oder mehrere vorgegebene freigegebene Bereiche für den zukünftigen Betrieb der Batterie zu berücksichtigen. Dies bedeutet, dass - obwohl im Zusammenhang mit der Zustandsvorhersage ein oder mehrere bestimmte Betriebsbereiche als besonders schädlich für die Alterung der Batterie identifiziert werden - aufgrund von vorgegebenen Präferenzen der Betrieb der Batterien den entsprechenden Betriebsbereichen nicht eingeschränkt werden kann. Diese freigegebenen Bereiche können Betriebsrandbedingungen und/oder das Betriebsprofil betreffen. Derart kann zum Beispiel - je nach Art des batteriebetriebenen Geräts - sichergestellt werden, dass keine Einschränkung der Funktionalität resultiert.

Es ist aber nicht in allen Beispielen notwendig, dass eine Rückkopplung der Ergebnisse der ein oder mehreren Zustandsvorhersagen in den Betrieb der Batterie erfolgt. Insoweit ist Block 1003 ein optionaler Block.

In manchen Beispielen wäre es alternativ oder zusätzlich möglich, dass Ergebnisse der Zustandsvorhersagen in einer Datenbank (vergleiche FIG. 1: Datenbank 82) gespeichert werden, siehe Block 1004. Zum Beispiel wäre es durch eine solche Hinterlegung möglich, durch späteren Vergleich des tatsächlichen Betriebsprofils während des Vorhersageintervalls 152 mit den hinterlegten Ergebnissen der ein oder mehreren Zustandsvorhersagen den Alterungszustand der Batterie besonders zügig zu bestimmen. Derart könnte zum Beispiel eine Zweitverwendung der Batterie gezielt gewählt werden, je nachdem ob der SOH 99 einen entsprechenden Einsatz der Batterie noch ermöglicht oder nicht. Außerdem könnte ein Training von maschinengelernten Modellen für die Alterungsschätzung erfolgen.

In manchen Beispielen wäre es alternativ oder zusätzlich möglich, dass Ergebnisse der Zustandsvorhersagen an einen Benutzer ausgegeben werden, beispielsweise über eine geeignete Mensch-Maschinen-Schnittstelle. Derart könnte der Benutzer zum Beispiel geeignete in den Betrieb der Batterie eingreifen, um eine übermäßige Alterung in Anbetracht der Zustandsvorhersagen zu vermeiden. Es können Betriebsrandbedingungen vom Benutzer festgelegt werden.

Das Durchführen von ein oder mehreren Zustandsvorhersagen in Block 1002 kann vergleichsweise viele Rechenressourcen benötigen. Dies bedeutet, dass der entsprechende Server, der typischerweise mit der Charakterisierung einer Vielzahl von Batterien betraut ist, das Durchführen der ein oder mehreren Zustandsvorhersagen in Abhängigkeit von ein oder mehreren Auslösekriterien selektiv auslösen könnte (zum Zeitpunkt 155, vgl. FIG. 5): derart kann vermieden werden, dass ständig eine erneute Zustandsvorhersage durchgeführt wird. Vielmehr kann das Durchführen von ein oder mehreren Zustandsvorhersagen bedarfsorientiert erfolgen. Beispielsweise wäre es möglich, dass der Server wiederholt das (z.B. kollektive oder Ereignis-bezogene) Betriebsprofil der Batterie für das Überwachungsintervall 151 erhält, vom entsprechenden Managementsystem, dass mit der Batterie assoziiert ist. Dann kann der Server eine Entwicklung des Betriebsprofils als Funktion der Zeit überwachen. Dies kann bedeuten, dass der Server Änderungen des Betriebsprofils zwischen zwei Zeitpunkten überprüft. In Abhängigkeit von einer solchen Überwachung ist es dann möglich, dass Durchführen der mindestens einen Zustandsvorhersage selektiv auszulösen. Wenn sich zum Beispiel ein oder mehrere Charakteristiken des Betriebsprofils verändern, so könnte das Durchführen der Zustandsvorhersage ausgelöst werden: dem liegt die Erkenntnis zugrunde, dass es in einer solchen Situation besonders wahrscheinlich sein kann, dass ein signifikanter Einfluss auf den Alterungszustand der Batterie aufgrund des geänderten Zustandsprofils vorliegt.

In einer anderen, einfachen Implementierung wäre es aber auch möglich, dass das Durchführen der ein oder mehreren Zustandsvorhersagen Block 1002 gemäß einem vorgegebenen Zeitplan durchgeführt wird, zum Beispiel in einer bestimmten Wiederholrate, etc.

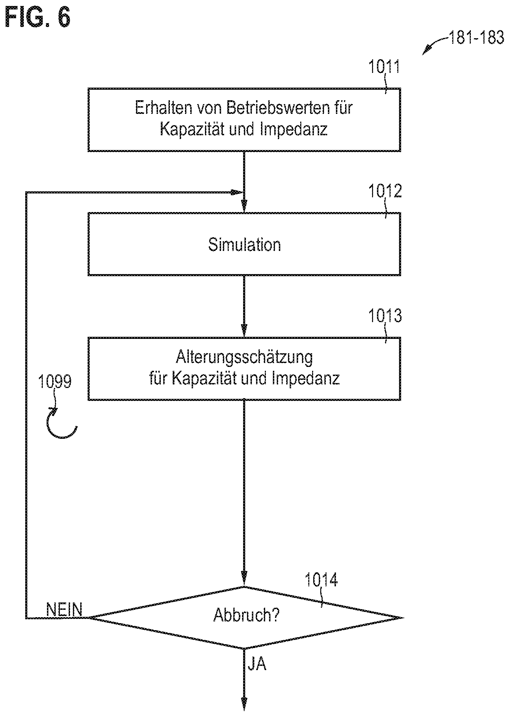

Als nächstes wird eine beispielhafte Implementierung des Durchführens der ein oder mehreren Zustandsvorhersagen in Block 1002 im Zusammenhang mit dem Flussdiagramm in FIG. 6 beschrieben.

FIG. 6 ist ein Flussdiagramm eines beispielhaften Verfahrens. Das Verfahren nach FIG. 6 kann von einem Server ausgeführt werden. Zum Beispiel wäre es möglich, dass das Verfahren gemäß FIG. 6 vom Prozessor 51 des Servers 81 basierend auf Programmcode aus dem Speicher 52 ausgeführt wird (vgl. FIG. 3).

Das Verfahren gemäß FIG. 6 dient der Zustandsvorhersage für eine Batterie. Wenn mehrere Zustandsvorhersagen durchgeführt werden sollen, wird das Verfahren nach FIG. 6 mehrfach durchgeführt.

In Block 1011 werden zunächst die Betriebswerte für die Kapazität und die Impedanz der jeweiligen Batterie erhalten. Block 1011 entspricht also Block 1001. Dies bedeutet, dass ein aktueller Wert für den SOH 99 der Batterie erhalten wird. Dies geschieht typischerweise basierend auf Zustandsdaten die vom jeweiligen Managementsystem, das mit der entsprechenden Batterie assoziiert ist, empfangen werden. Diese Betriebswerte dienen der Initialisierung der Zustandsvorhersage.

Dann werden mehrere Iterationen 1099 der Blöcke 1012-1014 durchgeführt. Die verschiedenen Iterationen 1099 entsprechen dabei Zeitschritten für die Zustandsvorhersage, d. h. fortschreitender Zeit während des Vorhersageintervalls 152.

Dabei erfolgt zunächst in Block 1012 die Simulation eines elektrischen Zustands der Batterie und eines thermischen Zustands der Batterie mittels entsprechender Simulationsmodule, für den jeweiligen Zeitschritt der entsprechenden Iteration 1099.

In Block 1012 erfolgt die Simulation unter Berücksichtigung einer entsprechenden Betriebsrandbedingung der Batterie. Diese hängt von der jeweiligen Zustandsvorhersage 181-183 ab. Außerdem kann ein entsprechendes Betriebsprofil für den Betrieb der Batterie angenommen werden.

Zur Simulation des elektrischen und thermischen Zustands kann eine elektrisches Simulationsmodul gekoppelt werden mit einem thermischen Simulationsmodul.

Das elektrische Simulationsmodul kann ein Ersatzschaltkreismodell (ECM) für die Batterie verwenden. Das ECM kann elektrische Bauelemente (Widerstand, Induktivität, Kapazität) umfassen. Die Parameter der Bauelemente des ECM können z.B. anhand eines Nyquist-Plots mit den charakteristischen Frequenzbereichen des Übertragungsverhaltens des Zellblocks der Batterie bestimmt werden.. Durch die Implementierung auf dem Server 81 kann die Anzahl der RC-Glieder besonders hoch gewählt werden, z.B. größer als drei oder vier. Dadurch kann eine besonders hohe Genauigkeit der elektrischen Simulation erzielt werden. Dabei kann je ein ECM für jede Zelle eines Zellblocks verwendet werden.

Das thermische Simulationsmodell ermöglicht es, den zeitliche Temperaturverlauf und optional die lokale Temperatur zu bestimmen. Dabei können Wärmequellen und Wärmesenken berücksichtigt werden. Die Wärmeabgabe an die Umgebung kann berücksichtigt werden. Details zu Wärmegenerationsmodell sind z.B. beschrieben in: D. Bernandi, E. Pawlikowski, und J. Newman, "A General Energy Balance for Battery Systems," Journal of the Electrochemical Society, 1985. Es können analytische oder numerische Modelle für die lokale Temperaturverteilung verwendet werden. Der Einfluss ein Thermomanagements kann berücksichtigt werden. Sh. z.B. M.-S. Wu, K. H. Liu, Y.-Y. Wang, und C.-C. Wan, "Heat dissipation design for lithium-ion batteries," Journal of Power Sources, Bd. 109, Rn. 1, S. 160-166, 2002.

Darauf basierend wird dann in Block 1013 eine Alterungsschätzung durchgeführt, d. h. die Kapazität und die Impedanz der Batterie werden für den jeweiligen Zeitschritt basierend auf einem Ergebnis der Simulation des elektrischen Zustands und des thermischen Zustands der Batterie bestimmt.

Im Zusammenhang mit der Alterungsschätzung können unterschiedliche Techniken verwendet werden. Die Alterungsschätzung kann zum Beispiel ein empirisches Alterungsmodell und/oder ein maschinengelerntes Alterungsmodell umfassen. Zum Beispiel könnte ein empirisches Alterungsmodell und ein maschinengelerntes Alterungsmodell parallel angewendet werden und dann Ergebnisse dieser beiden Alterungsmodelle durch Mittelung, beispielsweise gewichtete Mittelung, zusammengeführt werden.

Als allgemeine Regel könnte das empirische Alterungsmodell ein oder mehrere empirisch bestimmte Parameter umfassen, welche ein Betriebsprofil der Batterie, welches aus der Simulation aus Block 1012 erhalten wird, in Bezug setzen zu einer Verschlechterung des SOH 99, beispielsweise einer Herabsetzung der Kapazität und/oder Erhöhung der Impedanz. Die Parameter können zum Beispiel in Labormessungen bestimmt werden. Ein beispielhaftes empirisches Alterungsmodell ist beschrieben in: J. Schmalstieg, S. Käbitz, M. Ecker, und D. U. Sauer, "A holistic aging model for Li(NiMnCo)O2 based 18650 lithium-ion batteries," Journal of Power Sources, Bd. 257, S. 325-334, 2014.

Im Gegensatz dazu kann ein maschinengelerntes Alterungsmodell kontinuierlich auf Grundlage von Zustandsdaten, die von unterschiedlichen Batterien desselben Typs erhalten werden, durch maschinelles Lernen angepasst werden. Zum Beispiel könnten künstliche neuronale Netzwerke, etwa Faltungsnetzwerk (engl. convolutional neural network), verwendet werden. Eine andere Technik umfasst die sogenannte Stützvektormethode (engl. support vector machine). Zum Beispiel können Daten von einem Ensemble von Batterien (vergleiche FIG. 1: Batterien 91-96) verwendet werden, um einen entsprechenden Algorithmus durch maschinelles Lernen zu trainieren.

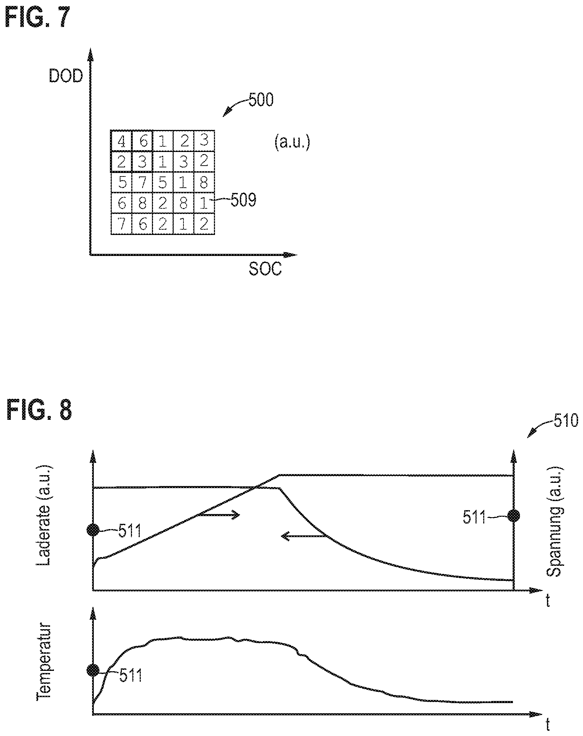

Unterschiedliche Alterungsmodelle können dabei unterschiedliche Eingaben aus der Simulation in Block 1012 empfangen. Zum Beispiel wäre es in einer Variante möglich, dass basierend auf den in mehreren Iterationen 1099 bestimmten simulierten elektrischen Zuständen und/oder simulierten thermischen Zuständen ein oder mehrere simulierte kollektive Betriebsprofile (manchmal auch als Lastkollektiv bezeichnet) für die Batterie bestimmt werden. Solche kollektive Betriebsprofile können jeweils die Häufigkeit des Betriebs der Batterie an bestimmten Betriebspunkten angeben. Dies bedeutet, dass ein kollektives Lastprofil vergleichbar mit einem Histogramms die Häufigkeit des Auftretens des Betriebs der Batterie an einem bestimmten Betriebspunkt quantifiziert, jedoch nicht eine Sequenz des Betriebs der Batterie an den Betriebspunkten oder einen konkreten Zeitpunkt für den Betrieb der Batterie an einem bestimmten Betriebspunkt angibt. FIG. 7 illustriert ein beispielhaftes simuliertes kollektives Betriebsprofil 500. Darin ist für unterschiedliche Betriebspunkte, die in den beiden Dimensionen Entladungstiefe (engl. depth of discharge, DOD) und Ladungszustand (engl. state of charge, SOC) definiert sind, die jeweilige Häufigkeit 509 des Betriebs der Batterie (in beliebigen Einheiten) angegeben. Der SOC gibt in Prozent den Status der aktuellen Ladung zur Kapazität der Batterie an. Die beiden Dimensionen DOD-SOC sind dabei aber lediglich Beispiele. Alternative Dimensionen, die im Zusammenhang mit kollektiven Betriebsprofilen für die Alterungsschätzung betrachtet werden können umfassen zum Beispiel: Ladungsrate; Temperatur beim Laden; Temperatur beim Entladen; Entladerate; etc. Es wäre auch möglich, kollektive Betriebsprofile mit mehr als zwei Dimensionen zu erstellen, z.B. mit drei oder vier Dimensionen.

Die Häufigkeit kann z.B. kalendarisch oder zyklisch indiziert sein. Dabei können verschiedene Zählverfahren eingesetzt werden, z.B. Spitzenwertzählung, Grenzüberschreitungszählung, Momentanwertzählung, Bereichszählung, Bereichspaar-Mittelwert-Zählung, Rainflow-Zählung (sh. z.B. DE102009006461A1), etc..

Zum Beispiel ist in FIG. 7 durch Hervorhebung illustriert, dass eine besonders starke Alterung der Batterie für große Entladungstiefen bei kleinen Ladungszuständen auftritt.

In einer weiteren Variante könnte - alternativ oder zusätzlich zu den ein oder mehreren simulierten kollektiven Betriebsprofilen - auch ein oder mehrere simulierte Ereignis-bezogene Betriebsprofile im Zusammenhang mit ein oder mehreren verwendeten Alterungsmodellen berücksichtigt werden. Ein beispielhaftes Ereignis-bezogenes Betriebsprofil 510 ist im Zusammenhang mit FIG. 8 illustriert. Dort ist der Zeitverlauf der Laderate, der Spannung zwischen den Polen der Batterie, sowie der Temperatur im Zusammenhang mit dem Ereignis einer Ladung der entsprechenden Batterie dargestellt. Außerdem sind auch entsprechende Mittelwerte 511 illustriert.

In manchen Beispielen wäre es denkbar, dass die Zeitverläufe von ein oder mehreren Größen, die das Ereignis charakterisieren (in FIG. 8 also die Laderate, die Spannung und die Temperatur) direkt im Zusammenhang mit dem Alterungsmodell berücksichtigt werden; es wäre aber auch denkbar, dass abgeleitete Größen (wie im Beispiel der FIG. 8 die Mittelwerte 511) berücksichtigt werden. In jedem Fall ist aus dem Beispiel der FIG. 8 auch ersichtlich, dass ein oder mehrere Größen eines Ereignis-basierten Betriebsprofils nicht im Zusammenhang mit der Häufigkeit des entsprechenden Betriebspunkts stehen, sondern auf das individuelle einzelne Ereignis bezogen sind.

Es ist möglich, dass die Alterungsschätzung mehrere Komponenten umfasst, beispielsweise eine erste Modellkomponente welche als Eingabe ein oder mehrere simulierte kollektive Betriebsprofile empfängt und ferner eine zweite Modellkomponente, welche als Eingabe ein oder mehrere simulierte Ereignis-bezogene Betriebsprofile empfängt. Es ist dann durch Berücksichtigung solcher unterschiedlicher Betriebsprofile möglich, die Alterungsschätzung besonders genau auszubilden. Zum Beispiel wäre es in diesem Zusammenhang möglich, dass die verschiedenen Komponenten der Alterungsschätzung zunächst separat durchgeführt werden und dann die Ergebnisse der verschiedenen Komponenten der Alterungsschätzung miteinander kombiniert werden, um derart ein Ergebnis der Alterungsschätzung zu erhalten

Wieder Bezug nehmend auf FIG. 6: Anschließend wird in Block 1014 überprüft, ob ein Abbruchkriterium erfüllt ist. Sofern dies nicht der Fall ist, wird Block 1012 erneut durchgeführt, für einen nächsten Zeitschritt im Vorhersageintervall 152, d.h. für die nächste Iteration 1099. Dabei werden die in der vorherigen Iteration 1099 bestimmten Kapazitäten und Impedanzen verwendet, d.h. die Simulationen in Block 1012 bauen aufeinander auf. Dies iterative Anpassung von Kapazität und Impedanz ermöglicht eine besonders genaue Zustandsvorhersage.

Wenn das Abbruchkriterium in Block 1014 erfüllt ist, ist die Zustandsvorhersage abgeschlossen. Beispiele für Abbruchkriterien umfassen: Anzahl von Iterationen 1099; Ende des Vorhersageintervalls 152 erreicht; Überschreitung bzw. Unterschreitung von Schwellenwerten für die Kapazität und/oder die Impedanz; etc.

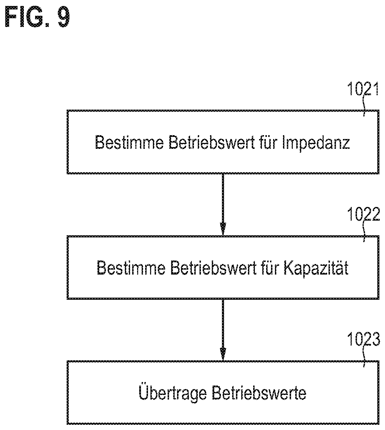

In vielen Beispielen kann es erstrebenswert sein, dass der initiale Betriebswert für die Impedanz und die Kapazität in Block 1011 mit einer besonders großen Genauigkeit verfügbar ist. Im Zusammenhang mit FIG. 9 ist eine beispielhafte Technik beschrieben, die dies ermöglicht.

FIG. 9 ist ein Flussdiagramm eines beispielhaften Verfahrens. Zum Beispiel kann das Verfahren der FIG. 9 Geräte-seitig auf eine Managementsystem, das mit einer Batterie assoziiert ist, durchgeführt werden. Zum Beispiel wäre es möglich, dass das Verfahren nach FIG. 9 auf dem Managementsystem 61 gemäß FIG. 2 ausgeführt wird. Es wäre aber auch möglich, dass das Verfahren der FIG. 9 Server-seitig durchgeführt wird.

Das Verfahren nach FIG. 9 ermöglicht es, die Kapazität und die Impedanz besonders genau zu bestimmen, auf Grundlage von Messdaten. Entsprechende Ist-Werte können während des normalen Betriebs im Feld bestimmt werden.

Zunächst wird in Block 1021 ein Betriebswert für die Impedanz bestimmt. Dies könnte zum Beispiel unter Verwendung eines ECM erfolgen. Der Betriebswert für die Impedanz kann zum Beispiel durch eine Parameterbestimmung von ein oder mehreren Bauteilen des ECM bestimmt werden. Das bedeutet, dass z.B. ein Widerstand eines R-Glieds des ECM bestimmt werden kann oder eine Induktivität eines L-Glieds oder eine Kapazität eines C-Glieds. Zum Beispiel wäre es möglich, dass der Betriebswert auf Grundlage von Zeitreihen für den Stromfluss und/oder die elektrische Spannung bestimmt wird.

Anschließend wird in Block 1022 ein Betriebswert für die Kapazität bestimmt. Dies kann zum Beispiel auf Grundlage von Ruhespannungen erfolgen, wie es zum Beispiel beschrieben ist in: M. Einhorn, F. V. Conte, C. ral, und J. Fleig, "A Method for Online Capacity Estimation of Lithium Ion Battery Cells Using the State of Charge and the Transferred Charge," IEEE Trans. on Ind. Applicat, Bd. 48, Rn. 2, S. 736-741, 2012.

Anschließend werden die in Blöcken 1021 - 1022 bestimmten Betriebswerte übertragen, zum Beispiel über eine entsprechende Kommunikationsschnittstelle an einen Server in Form von Zustandsdaten (vergleiche FIG. 1: Zustandsdaten 41). Insoweit ist Blick 1023 entsprechend zu Block 1001 oder 1011.

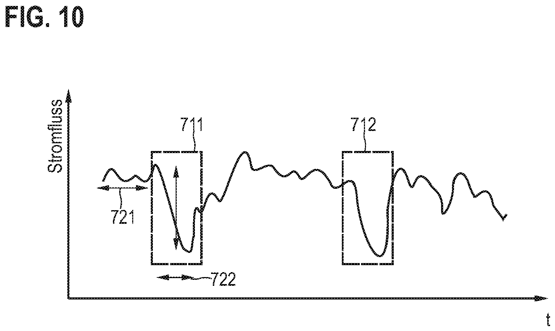

FIG. 10 illustriert Aspekte im Zusammenhang mit dem Bestimmen eines Betriebswerts für die Impedanz einer Batterie, z.B. gemäß Block 1021 aus FIG. 9. Die entsprechenden Techniken, wie sie im Zusammenhang mit dem Beispiel der FIG. 10 illustriert sind, können zum Beispiel auf einem lokalen Managementsystem, das mit einer Batterie assoziiert ist, ausgeführt werden (beispielsweise auf dem Managementsystem 61 gemäß FIG. 2). Ein Ergebnis der entsprechenden Auswertung könnte dann zum Beispiel in Form der Zustandsdaten 41 einen Server 81 übertragen werden. Dies bedeutet, dass der Betriebswert für die Impedanz Geräte-seitig bei der Batterie bestimmt werden kann. Es wäre aber auch möglich, die entsprechende Bestimmung Server-seitig vorzunehmen.

In FIG. 10 ist eine Zeitreihe von Messwerten für den Stromfluss in ein oder mehreren Zellen der Batterie dargestellt. Anhand des zeitlichen Verlaufs des Stromflusses (bzw. alternativ oder zusätzlich anhand des zeitlichen Verlaufs der Spannung und/oder anderer Kenngrößen des elektrischen Betriebs der Batterie) ist es möglich, den Betriebswert für die Impedanz der Batterie zu bestimmen. Es könnten auch ein oder mehrere Kenngrößen des thermischen Betriebs berücksichtigt werden.

Gemäß verschiedener Beispiele wird dies dadurch erreicht, dass aus der Zeitreihe von Stromfluss und/oder Spannung Werte extrahiert werden, im Beispiel der FIG. 10 innerhalb der Sprungfenster 711, 712. Dann können ein oder mehrere Analysealgorithmen auf die extrahierten Werte für jedes Sprungfenster angewendet werden. Zum Beispiel könnten ein oder mehrere Analysealgorithmen auf die Werte im Sprungfenster 711 angewendet werden und die ein oder mehreren Analysealgorithmen können anschließend auch auf die Werte im Sprungfenster 712 angewendet werden. Indem die Werte aus der durchgängigen Zeitreihe extrahiert werden, kann erreicht werden, dass eine Echtzeitbearbeitung ermöglicht wird, weil die Datengrundlage reduziert wird. Die ein oder mehreren Analysealgorithmen können sequenziell und/oder parallel auf den für ein bestimmtes Sprungfenster 711, 712 extrahierten Werten operieren. Für die verschiedenen Sprungfenster 711, 712 können dann Kandidatenwerte für die Impedanz erhalten werden, die anschließend kombiniert werden können, um den entsprechenden Betriebswert zu erhalten.

Solche Techniken beruhen auf der Erkenntnis, dass es oftmals möglich ist, für die Impedanz besonders relevante zeitliche Verläufe von Strom und/oder Spannung aus der kontinuierlichen Zeitreihe der entsprechenden Daten zu extrahieren.

Insbesondere wäre es möglich, dass die ein oder mehreren Sprungfenster 711, 712 so bestimmt werden, dass sie entsprechende relevante Daten umfassen. Im Allgemeinen können ein oder mehrere Sprungfenster 711, 712 basierend auf einer Analyse der Zeitreihe der Stromdaten und/oder Spannungsdaten hinsichtlich ein oder mehrere Kriterien bestimmt werden. Beispielsweise könnten die Kriterien aus folgender Gruppe ausgewählt sein: Zeitdauer 722 eines Entladungsvorgangs; Ladungsmenge des Entladungsvorgangs; Ruhephase 721 vor dem Entladevorgang; bzw. ein oder mehrerer solcher Parameter auch im Zusammenhang mit einem Ladungsvorgang (statt einem Entladungsvorgang).

Solche Techniken beruhen auf der Erkenntnis, dass anstelle von definierten Relaxationszeiten und Pulsbelastungen wie in der Laborparametrierung in der Fahrzeuganwendung im Feld oftmals eine stark fluktuierende und undefinierte Stromanregung vorliegen kann. Um in der Parameterbestimmung für das ECM im Zusammenhang mit der Ermittlung des Betriebswerts der Impedanz dennoch sinnvolle Werte ermitteln zu können, werden im Fenstersuch-Prozess die oben beschriebenen Sprungfenster 711, 712 ausgewählt. Ausgangspunkt ist hierbei beispielsweise ein Ringspeicher definierter Länge. In diesem werden Strom- und Spannungsmesswerte des BMS ungefiltert mit der Samplingrate entsprechend dem First-In-First-Out-Prinzip (FiFo) abgelegt. In jedem Zeitschritt wird der gesamte Ringspeicher mit einem Satz vordefinierter Musterfenster - welche die Kriterien definieren - verglichen. Erfüllt ein Abschnitt die Kriterien eines Musterfensters, werden die Messwerte extrahiert für die weitere Analyse.

Beispiele für entsprechende Kriterien umfassen: Für die Parameterbestimmung müssen die Anfangswerte der RC-Glieder bekannt sein. Liegt für einen ausreichend langen Zeitraum 721 ein konstanter Strom, kann der entsprechende Widerstand des ECM bestimmt werden. Der Start eines Sprungfensters 711, 712 sollte daher nach einem Zeitintervall 721 mit möglichst konstantem Strom definiert werden. Das zweite Kriterium der Sprungfensterwahl bezieht sich auf die Dynamik von Strom- und Spannungssignal im Sprungfenster 711, 712 selbst. Hierbei kann beachtet werden, dass der abzubildende dynamische Effekt (bspw. Diffusion) auch in ausreichendem Maße durch die Strombelastung angeregt wird. Wird bspw. am Anfang einer Fahrt bei relaxierten Batteriezellen ein Fenster mit zu geringem Ladungsdurchsatz gewählt, ist der Diffusionseffekt möglicherweise zu schwach ausgeprägt und die entsprechende Parameterbestimmung nicht sinnvoll möglich. Neben Strom und Spannung wird daher beispielsweise die inkrementelle Ladungsmenge berücksichtigt. Bei Effekten mit ausgeprägter Stromratenabhängigkeit, wie dem Ladungsträgerdurchtritt, sollte zudem ein möglichst stufenartiger Stromsprung identifiziert werden, um die Stromratenabhängigkeit der Parameter richtig einordnen zu können.

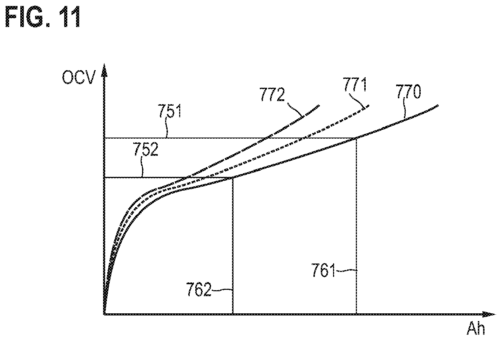

FIG. 11 illustriert Aspekte im Zusammenhang mit dem Bestimmen eines Betriebswerts für die Kapazität einer Batterie, z.B. gemäß Block 1022 aus FIG. 9. Die entsprechenden Techniken, wie sie im Zusammenhang mit dem Beispiel der FIG. 11 illustriert sind, können zum Beispiel auf einem lokalen Managementsystem, das mit einer Batterie assoziiert ist, ausgeführt werden (beispielsweise auf dem Managementsystem 61 gemäß FIG. 2). Ein Ergebnis der entsprechenden Auswertung könnte dann zum Beispiel in Form der Zustandsdaten 41 einen Server 81 übertragen werden. Dies bedeutet, dass der Betriebswert für die Impedanz Geräte-seitig bei der Batterie bestimmt werden kann. Es wäre aber auch möglich, die entsprechende Bestimmung Server-seitig vorzunehmen.

In FIG. 11 ist die Ruhespannung (engl. open circuit voltage, OCV) als Funktion des Ladungszustands (Amperstunden) dargestellt. Der Ladungszustand korreliert mit dem SOC. Die OCV hängt über eine Ruhespannungs-Kennlinie vom Ladungszustand ab. In FIG. 11 sind zwei Ruhespannungen 751, 752 dargestellt, sowie der jeweils assoziierte Ladungszustand 761, 762. Der Ladungszustand 761, 762 wird unter Berücksichtigung der vorgegebenen Kennlinie 770 bestimmt. Z.B. kann eine Lookup-Tabelle implementiert werden. Aus einer linearen Interpolation der beiden Ladungszustand 761, 762 (unter Berücksichtigung der gegebenenfalls gestauchten Kennlinie 770-772) im Zusammenhang mit dem assoziierten Ladungsdurchsatz, kann dann auf die Kapazität der Batterie zurück geschlossen werden.

In den verschiedenen hierin beschriebenen Beispielen kann ein Stauchungsfaktor für die Kennlinie 770 bestimmt werden, um gestauchte Kennlinien 771, 772 zu erhalten. Der Stauchungsfaktor wird in Abhängigkeit von einer weiteren Alterungsschätzung für die Batterie bestimmt, die verschieden ist von der Alterungsschätzung die dann anschließend auf Grundlage der bestimmten Kapazität durchgeführt wird (d. h. die weitere Alterungsschätzung ist verschieden von der Alterungsschätzung die zum Beispiel in Block 1013 gemäß FIG. 6 durchgeführt wird). Die weitere Alterungsschätzung und die auf Grundlage der bestimmten Kapazität durchgeführte Alterungsschätzung können unabhängig voneinander sein. Dem liegt die Erkenntnis zugrunde, dass die Kennlinie 770 als Funktion des Alterungszustands variieren kann.

Im Allgemeinen sind unterschiedliche Techniken im Zusammenhang mit der weiteren Alterungsschätzung möglich. In einem Beispiel wäre es zum Beispiel denkbar, dass Interkalationspotentiale im Zusammenhang mit einer Lithium-Ionen-Batterie überwacht werden. Interkalationspotentiale stellen Peaks in der dV/dQ-Kurve während bspw. des Ladevorgangs einer Batterie dar. Sie stellen die Übergänge der verschiedenen Stufen des Interkalationsprozesses in der Graphit-Anode dar. Ihre Höhe und/oder ihr Abstand ist charakteristisch für den Alterungszustand der Batterie und kann daher im Rahmen der beschriebenen Methode genutzt werden.

Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne das Gebiet der Erfindung zu verlassen.

Beispielsweise wurden voranstehend verschiedene Techniken im Zusammenhang mit einer Zustandsvorhersage für eine Batterie beschrieben. Solche Techniken können auch für individueller Blöcke der Batterie oder Zellen oder Zellgruppen der Batterie implementiert werden.

Ferner wurden voranstehend Techniken im Zusammenhang mit der Charakterisierung bzw. der Zustandsvorhersage für eine Batterie beschrieben. Diese Ergebnisse können zur Einstellung des zukünftigen Betriebsprofils der Batterie verwendet werden. Es wäre denkbar, dass solche Ergebnisse an einen Benutzer der Batterie ausgegeben werden, über eine geeignete Mensch-Maschinen-Schnittstelle. Dann kann es dem Benutzer ermöglicht werden, das zukünftige Betriebsprofil auf Grundlage einer solchen Information über den Zustand der Batterie auszuwählen. Dies entspricht einer Mensch-Maschine-Interaktion zur Steuerung der Batterie.

## Patentansprüche

1. Verfahren zur Server-seitigen Charakterisierung einer wiederaufladbaren Batterie (91-96), das umfasst:
- Erhalten von Betriebswerten für eine Kapazität der Batterie (91-96) und eine Impedanz der Batterie (91-96),
- basierend auf den Betriebswerten: Durchführen von mindestens einer Zustandsvorhersage (181-183) für die Batterie (91-96),
wobei eine Simulation eines elektrischen Zustands der Batterie (91-96) und eines thermischen Zustands der Batterie (91-96) durchgeführt wird und darauf basierend eine Alterungsschätzung für die Kapazität und die Impedanz bestimmt wird, **dadurch gekennzeichnet, dass**: 11
jede der mindestens einen Zustandsvorhersage (181-183) mehrere Iterationen (1099) umfasst, wobei in jeder Iteration die Simulation durchgeführt und darauf basierend die Alterungsschätzung für die Kapazität und die Impedanz bestimmt wird,
wobei die Alterungsschätzung aus einer ersten Iteration (1099) der jeweiligen Zustandsvorhersage (181-183) für die Simulation in einer nachfolgenden zweiten Iteration (1099) der jeweiligen Zustandsvorhersage (181-183) verwendet wird.

2. Verfahren nach Anspruch 1,
wobei jede der mindestens einen Zustandsvorhersage (181-183) mit einer entsprechenden Betriebsrandbedingung der Batterie (91-96) assoziiert ist,
wobei die mindestens eine Zustandsvorhersage (181-183) mehrere Zustandsvorhersagen (181-183) umfasst, die mit unterschiedlichen Betriebsrandbedingungen assoziiert sind,
wobei das Verfahren weiterhin umfasst:
- Vergleichen von Ergebnissen der mehreren Zustandsvorhersagen (181-183), und
- basierend auf dem Vergleichen der Ergebnisse: Bestimmen von Steuerdaten (42) für ein mit der Batterie (91-96) assoziiertes Managementsystem (61) sowie Senden der Steuerdaten (42) an das Managementsystem (61).

3. Verfahren nach Anspruch 2,
wobei die Steuerdaten (42) indikativ für ein oder mehrere Elemente der folgenden Gruppe sind: ein oder mehrere Betriebsgrenzen (552) für einen zukünftigen Betrieb der Batterie (91-96), wobei die Betriebsgrenzen (552) mit ein oder mehreren Betriebsrandbedingungen oder einem Betriebsprofil der Batterie (91-96) assoziiert sind; ein Steuerparameter für ein Thermomanagement der Batterie (91-96); und ein Steuerparameter für ein Lademanagement der Batterie (91-96),
wobei die Steuerdaten (42) weiterhin basierend auf vorgegebenen freigegebenen Bereichen (551) für den zukünftigen Betrieb bestimmt werden.

4. Verfahren nach einem der voranstehenden Ansprüche,
wobei die Betriebsrandbedingungen ein oder mehrere der folgenden Elemente betreffen: ein Steuerparameter eines Thermomanagements der Batterie (91-96); und ein Steuerparameter eines Lademanagements der Batterie (91-96).

5. Verfahren nach einem der voranstehenden Ansprüche,
wobei jede der mindestens einen Zustandsvorhersage (181-183) mit einem entsprechenden Betriebsprofil der Batterie (91-96) der Batterie assoziiert ist.

6. Verfahren nach einem der voranstehenden Ansprüche, das weiterhin umfasst:
- basierend auf den in mehreren Iterationen (1099) der mindestens einen Zustandsvorhersage (181-183) simulierten elektrischen Zuständen und/oder den simulierten thermischen Zuständen: Bestimmen von ein oder mehreren simulierten kollektiven Betriebsprofilen (500) für die Batterie (91-96), die jeweils eine Häufigkeit des Betriebs der Batterie (91-96) bei bestimmten Betriebspunkten angeben, und
- optional Verwenden der ein oder mehreren simulierten kollektiven Betriebsprofile (500) für die Alterungsschätzungen in den Iterationen (1099).

7. Verfahren nach einem der voranstehenden Ansprüche, das weiterhin umfasst:
- basierend auf dem in mindestens einer Iteration (1099) der mindestens einen Zustandsvorhersage (181-183) simulierten elektrischen Zustand und/oder dem simulierten thermischen Zustand: Bestimmen von ein oder mehreren simulierten Ereignis-bezogene Betriebsprofile (510) für die Batterie (91-96), und
- optional Verwenden der ein oder mehreren simulierten Ereignis-bezogene Betriebsprofile (510)für die Alterungsschätzungen in den Iterationen (1099).

8. Verfahren nach Anspruch 6 und 7,
wobei die Alterungsschätzungen in den Iterationen (1099) eine erste Komponente basierend auf den ein oder mehreren simulierten kollektiven Betriebsprofilen umfassen,
wobei die Alterungsschätzungen in den Iterationen (1099) eine zweite Komponente basierend auf den ein oder mehreren simulierten Ereignis-bezogene Betriebsprofilen umfassen,
wobei das Verfahren weiterhin umfasst:
- Kombinieren von Ergebnissen der ersten Komponente der Alterungsschätzung und der zweiten Komponente der Alterungsschätzung.

9. Verfahren nach einem der voranstehenden Ansprüche,
wobei die Alterungsschätzungen in den Iterationen (1099) zumindest eines von einem empirischen Alterungsmodell und einem maschinengelernten Alterungsmodell verwenden.

10. Verfahren nach einem der voranstehenden Ansprüche, das weiterhin umfasst:
- Bestimmen des Betriebswerts für die Impedanz,
wobei das Bestimmen des Betriebswert für die Impedanz umfasst:
- Extrahieren von Werten aus einer Zeitreihe von Strom-Spannungsdaten der Batterie (91-96) für ein oder mehrere Sprungfenster (711, 712),
- für jedes Sprungfenster (711, 712): Anwenden eines Analysealgorithmus auf die extrahierten Werte zum Bestimmen eines entsprechenden Kandidatenwerts für die Impedanz unter Verwendung eines elektrischen Ersatzschaltkreismodells, und
- Kombinieren der Kandidatenwerte, die mit den mehreren Sprungfenstern (711, 712) assoziiert sind, zum Erhalten des Betriebswert.

11. Verfahren nach Anspruch 10, das weiterhin umfasst:
- Bestimmen der ein oder mehreren Sprungfenster (711, 712) basierend auf einer Analyse der Zeitreihe von Strom-Spannungsdaten hinsichtlich ein oder mehrerer Kriterien (721, 722),
wobei die ein oder mehreren Kriterien ausgewählt sind aus: Zeitdauer eines Entladevorgangs; Ladungsmenge eines Entladungsvorgangs; Ruhephase (721) vor dem Entladungsvorgang; Zeitdauer eines Ladevorgangs; und Ladungsmenge eines Ladevorgangs.

12. Verfahren nach einem der voranstehenden Ansprüche, das weiterhin umfasst:
- Bestimmen des Betriebswerts für die Kapazität,
wobei das Bestimmen des Betriebswerts für die Kapazität umfasst:
- Bestimmen einer ersten Ruhespannung bei einem ersten teilentladenen Zustand und einer zweiten Ruhespannung bei einem zweiten teilentladenen Zustand,
- Bestimmen eines Ladungsdurchsatzes zwischen dem ersten teilentladenen Zustand und dem zweiten Teilentladenen zustand,
- basierend auf einer vorgegebenen Kennlinie: Bestimmen eines Ladungszustands (761) der Batterie (91-96) für die erste Ruhespannung,
- basierend auf der vorgegebenen Kennlinie: Bestimmen eines zweiten Ladungszustands (762) der Batterie (91-96) für die erste Ruhespannung,
- Bestimmen der Kapazität basierend auf dem ersten Ladungszustand, dem zweiten Ladungszustand und dem Ladungsdurchsatz, und
- Bestimmen eines Stauchungsfaktors für die Kennlinie basierend auf einer weiteren Alterungsschätzung der Batterie (91-96).

13. Verfahren nach Anspruch 13, das weiterhin umfasst:
- Durchführen der weiteren Alterungsschätzung basierend auf einer Überwachung von Interkalationspotentialen der Batterie (91-96).

14. Verfahren nach einem der voranstehenden Ansprüche, das weiterhin umfasst:
- Erhalten eines Betriebsprofils der Batterie (91-96) für ein Überwachungsintervall (151) von einem Managementsystem (61), das mit der Batterie (91-96) assoziiert ist,
- Überwachen einer Entwicklung des Betriebsprofils, und
- Auslösen des Durchführens der mindestens einen Zustandsvorhersage (181-183) basierend auf dem Überwachen der Entwicklung.

15. Verfahren nach einem der voranstehenden Ansprüche, das weiterhin umfasst:
- Erhalten eines Betriebsprofils der Batterie (91-96) für ein Überwachungsintervall (151) von einem Managementsystem (61), das mit der Batterie (91-96) assoziiert ist,
wobei die mindestens eine Zustandsvorhersage (181-183) auf dem Betriebsprofil der Batterie (91-96) basiert.

## Claims

1. Method for server-side characterization of a rechargeable battery (91-96), which comprises:
- obtaining operating values for a capacity of the battery (91-96) and an impedance of the battery (91-96),
- based on the operating values: performing at least one state prediction (181-183) for the battery,
wherein a simulation of an electrical state of the battery (91-96) and a thermal state of the battery (91-96) is performed and an aging estimate for the capacity and the impedance is determined based on the results, **characterized in that**:
each of the at least one state prediction (181-183) comprises a plurality of iterations (1099), wherein in each iteration the simulation is performed and the aging estimate for the capacity and the impedance is determined based on the results,
wherein the aging estimate from a first iteration (1099) of the respective state prediction (181-183) is used for the simulation in a subsequent second iteration (1099) of the respective state prediction (181-183) .

2. Method according to Claim 1,
wherein each of the at least one state predictions (181-183) is associated with a corresponding operating boundary condition of the battery (91-96),
wherein the at least one state prediction (181-183) comprises a plurality of state predictions (181-183) that are associated with different operating boundary conditions,
the method additionally comprising:
- comparing results of the plurality of state predictions (181-183), and
- based on the comparison of the results: determining control data (42) for a management system (61) associated with the battery (91-96) and sending the control data (42) to the management system (61).

3. Method according to Claim 2,
wherein the control data (42) is indicative of one or more elements of the following group: one or more operating limits (552) for a future operation of the battery (91-96), the operating limits (552) being associated with one or more operating boundary conditions or an operating profile of the battery (91-96); a control parameter for a thermal management of the battery (91-96); and a control parameter for a charge management of the battery (91-96),
wherein the control data (42) data is additionally determined based on pre-defined enabled ranges (551) for the future operation.

4. Method according to any of the preceding claims,
wherein the operating boundary conditions relate to one or more of the following elements: a control parameter of a thermal management system of the battery (91-96); and a control parameter of a charge management system of the battery (91-96).

5. Method according to any of the preceding claims,
wherein each of the at least one state predictions (181-183) is associated with a corresponding operating profile of the battery (91-96).

6. Method according to any of the preceding claims, additionally comprising:
- based on the simulated electrical states and/or the simulated thermal states in a plurality of iterations (1099) of the at least one state prediction (181-183) : determining one or more simulated collective operating profiles (500) for the battery (91-96), each indicating a frequency of operation of the battery (91-96) at specific operating points, and
- optionally using the one or more simulated collective operating profiles (500) for the aging estimates in the iterations (1099).

7. Method according to any of the preceding claims, additionally comprising:
- based on the simulated electrical state and/or the simulated thermal state in at least one iteration (1099) of the at least one state prediction (181-183): determining one or more simulated event-related operating profiles (510) for the battery (91-96), and
- optionally using the one or more simulated event-related operating profiles (510) for the aging estimates in the iterations (1099).

8. Method according to Claim 6 and 7,
wherein the aging estimates in the iterations (1099) comprise a first component based on one or more simulated collective operating profiles,
wherein the aging estimates in the iterations (1099) comprise a second component based on the one or more simulated event-related operating profiles,
the method additionally comprising:
- combining results of the first component of the aging estimate and the second component of the aging estimate.

9. Method according to any of the preceding claims,
wherein the aging estimates in the iterations (1099) use at least one of an empirical aging model and a machine-learning aging model.

10. Method according to any of the preceding claims, additionally comprising:
- determining the operating value for the impedance,
wherein determining the operating value for the impedance comprises:
- extracting values from a time series of current-voltage data of the battery (91-96) for one or more jump windows (711, 712),
- for each jump window (711, 712) : applying an analysis algorithm to the extracted values to determine a corresponding candidate value for the impedance using an equivalent electrical circuit model, and
- combining the candidate values associated with the multiple jump windows (711, 712) to obtain the operating value.

11. Method according to Claim 10, additionally comprising:
- determining the one or more jump windows (711, 712) based on an analysis of the time series of current-voltage data with respect to one or more criteria (721, 722),
wherein the one or more criteria are selected from: duration of a discharge operation; charge quantity of a discharge operation; rest phase (721) before the discharge operation; duration of a charging operation; and charge quantity of a charging operation.

12. Method according to any of the preceding claims, additionally comprising:
- determining the operating value for the capacity,
wherein determining the operational value for the capacity comprises:
- determining a first open-circuit voltage in a first partially discharged state and a second open-circuit voltage in a second partially discharged state,
- determining a charge throughput between the first partially discharged state and the second partially discharged state,
- based on a pre-defined characteristic curve: determining a charge state (761) of the battery (91-96) for the first open-circuit voltage,
- based on the pre-defined characteristic curve: determining a second charge state (762) of the battery (91-96) for the first open-circuit voltage,
- determining the capacity based on the first charge state, the second charge state, and the charge throughput, and
- determining a compression factor for the characteristic curve based on a further aging estimate of the battery (91-96).

13. Method according to Claim 12, additionally comprising:
- performing the additional aging estimation based on monitoring of intercalation potentials of the battery (91-96).

14. Method according to any of the preceding claims, additionally comprising:
- obtaining an operating profile of the battery (91-96) for a monitoring interval (151) from a management system (61) associated with the battery (91-96),
- monitoring a development of the operating profile, and
- triggering the performing of at least one state prediction (181-183) based on the monitoring of the development.

15. Method according to any of the preceding claims, additionally comprising:
- obtaining an operating profile of the battery (91-96) for a monitoring interval (151) from a management system (61) associated with the battery (91-96),
wherein the at least one state prediction (181-183) is based on the operating profile of the battery (91-96) .

## Revendications

1. Procédé de caractérisation côté serveur d'une batterie (91-96) rechargeable, comprenant :
- l'obtention de valeurs de fonctionnement pour une capacité de la batterie (91-96) et une impédance de la batterie (91-96),
- sur la base des valeurs de fonctionnement : la mise en œuvre d'au moins une prédiction d'état (181-183) de la batterie (91-96),
dans lequel une simulation d'un état électrique de la batterie (91-96) et d'un état thermique de la batterie (91-96) est réalisée, et une estimation de vieillissement de la capacité et de l'impédance est déterminée sur cette base, **caractérisé en ce que** :
chacune de ladite au moins une prédiction d'état (181-183) comprend plusieurs itérations (1099), la simulation étant réalisée lors de chaque itération et l'estimation de vieillissement de la capacité et de l'impédance étant déterminée sur cette base,
dans lequel l'estimation de vieillissement issue d'une première itération (1099) de la prédiction d'état (181-183) respective est utilisée pour la simulation lors d'une seconde itération (1099) suivante de la prédiction d'état (181-183) respective.

2. Procédé selon la revendication 1,
dans lequel chacune de ladite au moins une prédiction d'état (181-183) est associée à une condition limite de fonctionnement correspondante de la batterie (91-96),
dans lequel ladite au moins une prédiction d'état (181-183) comprend plusieurs prédictions d'état (181-183) qui sont associées à différentes conditions limites de fonctionnement,
dans lequel le procédé comprend en outre :
- la comparaison de résultats de plusieurs prédictions d'état (181-183), et
- sur la base de la comparaison des résultats : la détermination de données de commande (42) d'un système de gestion (61) associé à la batterie (91-96) et l'envoi des données de commande (42) au système de gestion (61).

3. Procédé selon la revendication 2,
dans lequel les données de commande (42) sont représentatives d'un ou plusieurs éléments du groupe suivant : une ou plusieurs limites de fonctionnement (552) pour un fonctionnement futur de la batterie (91-96), les limites de fonctionnement (552) étant associées à une ou plusieurs conditions limites de fonctionnement ou à un profil de fonctionnement de la batterie (91-96) ; un paramètre de commande pour une gestion thermique de la batterie (91-96) ; et un paramètre de commande pour une gestion de la charge de la batterie (91-96),
dans lequel les données de commande (42) sont en outre déterminées sur la base de zones validées (551) prédéterminées pour le fonctionnement futur.

4. Procédé selon l'une des revendications précédentes, dans lequel les conditions limites de fonctionnement sont relatives à un ou plusieurs des éléments suivants : un paramètre de commande d'une gestion thermique de la batterie (91-96) ; et un paramètre de commande d'une gestion de charge de la batterie (91-96).

5. Procédé selon l'une des revendications précédentes, dans lequel chacune de ladite au moins une prédiction d'état (181-183) est associée à un profil de fonctionnement correspondant de la batterie (91-96).

6. Procédé selon l'une des revendications précédentes, comprenant en outre :
- sur la base des états électriques simulés et/ou des états thermiques simulés lors de plusieurs itérations (1099) de ladite au moins une prédiction d'état (181-183) : la détermination d'un ou plusieurs profils de fonctionnement collectifs simulés (500) pour la batterie (91-96), qui indiquent respectivement une fréquence du fonctionnement de la batterie (91-96) en des points de fonctionnement déterminés, et
- facultativement, l'utilisation desdits un ou plusieurs profils de fonctionnement collectifs simulés (500) pour les estimations de vieillissement lors des itérations (1099) .

7. Procédé selon l'une des revendications précédentes, comprenant en outre :
- sur la base de l'état électrique simulé et/ou de l'état thermique simulé lors d'au moins une itération (1099) de ladite au moins une prédiction d'état (181-183) : la détermination d'un ou plusieurs profils de fonctionnement simulés liés à des événements (510) de la batterie (91-96), et
- facultativement, l'utilisation desdits un ou plusieurs profils de fonctionnement simulés liés à des événements (510) pour les estimations de vieillissement lors des itérations (1099).

8. Procédé selon les revendications 6 et 7,
dans lequel les estimations de vieillissement lors des itérations (1099) comprennent une première composante basée sur lesdits un ou plusieurs profils de fonctionnement collectifs simulés,
dans lequel les estimations de vieillissement lors des itérations (1099) comprennent une seconde composante basée sur lesdits un ou plusieurs profils de fonctionnement simulés liés à des événements,
dans lequel le procédé comprend en outre :
- la combinaison de résultats de la première composante de l'estimation de vieillissement et de la seconde composante de l'estimation de vieillissement.

9. Procédé selon l'une des revendications précédentes, dans lequel les estimations de vieillissement lors des itérations (1099) utilisent au moins l'un d'un modèle de vieillissement empirique et d'un modèle de vieillissement appris par apprentissage automatique.

10. Procédé selon l'une des revendications précédentes, comprenant en outre :
- la détermination de la valeur de fonctionnement pour l'impédance,
dans lequel la détermination de la valeur de fonctionnement pour l'impédance comprend :
- l'extraction de valeurs d'une série temporelle de données courant-tension de la batterie (91-96) pour une ou plusieurs fenêtres de saut (711, 712),
- pour chaque fenêtre de saut (711, 712) : l'application d'un algorithme d'analyse aux valeurs extraites pour déterminer une valeur candidate correspondante pour l'impédance en utilisant un modèle de circuit électrique équivalent, et
- la combinaison des valeurs candidates associées aux multiples fenêtres de saut (711, 712) pour obtenir la valeur de fonctionnement.

11. Procédé selon la revendication 10, comprenant en outre :
- la détermination desdites une ou plusieurs fenêtres de saut (711, 712) sur la base d'une analyse de la série temporelle de données courant-tension par rapport à un ou plusieurs critères (721, 722),
dans lequel lesdits un ou plusieurs critères sont choisis parmi : la durée d'un processus de décharge ; le niveau de charge d'un processus de décharge ; la phase de repos (721) avant le processus de décharge ; la durée d'un processus de charge ; et le niveau de charge d'un processus de charge.

12. Procédé selon l'une des revendications précédentes, comprenant en outre :
- la détermination de la valeur de fonctionnement pour la capacité,
dans lequel la détermination de la valeur de fonctionnement pour la capacité comprend :
- la détermination d'une première tension de repos dans un premier état de décharge partielle et une seconde tension de repos dans un second état de décharge partielle,
- la détermination d'un débit de charge entre le premier état de décharge partielle et le second état de décharge partielle,
- sur la base d'une courbe caractéristique prédéfinie : la détermination d'un état de charge (761) de la batterie (91-96) pour la première tension de repos,
- sur la base de la courbe caractéristique prédéfinie : la détermination d'un second état de charge (762) de la batterie (91-96) pour la première tension de repos,
- la détermination de la capacité sur la base du premier état de charge, du second état de charge et du débit de charge, et
- la détermination d'un facteur d'écrasement de la courbe caractéristique sur la base d'une autre estimation de vieillissement de la batterie (91-96).

13. Procédé selon la revendication 13, comprenant en outre :
- la réalisation de l'autre estimation de vieillissement sur la base d'une surveillance de potentiels d'intercalation de la batterie (91-96).

14. Procédé selon l'une des revendications précédentes, comprenant en outre :
- l'obtention d'un profil de fonctionnement de la batterie (91-96) pour un intervalle de surveillance (151) par un système de gestion (61) qui est associé à la batterie (91-96),
- la surveillance d'une évolution du profil de fonctionnement, et
- le déclenchement de la réalisation de ladite au moins une prédiction d'état (181 - 183) sur la base de la surveillance de l'évolution.

15. Procédé selon l'une des revendications précédentes, comprenant en outre :
- l'obtention d'un profil de fonctionnement de la batterie (91-96) pour un intervalle de surveillance (151) par un système de gestion (61) qui est associé à la batterie (91-96),
dans lequel ladite au moins une prédiction d'état (181-183) est basée sur le profil de fonctionnement de la batterie (91-96).
